# EUROPÄISCHE PATENTSCHRIFT

(11) **EP 1 369 904 B1**
(45) Veröffentlichungstag und Bekanntmachung des Hinweises auf die Patenterteilung: **21.01.2009**
(21) Anmeldenummer: 03017235.7
(22) Anmeldetag: 31.10.2000
(51) Int. Cl.: H01L 21/00

(54) **Vorrichtung zur Flüssigkeitsbehandlung von scheibenförmigen Gegenständen**
Apparatus for liquid treatment of wafers
Dispositif de traitement de plaquettes

(43) Veröffentlichungstag der Anmeldung: 10.12.2003
(62) Teilanmeldung aus: 00123714.8
(73) Patentinhaber: SEZ AG, 9500 Villach (AT)
(72) Erfinder: Engesser, Philipp, Dipl.-Ing. (FH), 88131 Lindau (DE)
(74) Vertreter: Kontrus, Gerhard

(56) Entgegenhaltungen:
- EP-A- 0 844 646
- EP-A- 1 052 682
- WO-A-95/22084
- US-A- 4 903 717
- US-A- 5 705 223
- PATENT ABSTRACTS OF JAPAN Bd. 003, Nr. 124 (E-144), 17. Oktober 1979 (1979-10-17) -& JP 54 101275 A (HITACHI LTD), 9. August 1979 (1979-08-09)
- PATENT ABSTRACTS OF JAPAN Bd. 1999, Nr. 12, 29. Oktober 1999 (1999-10-29) -& JP 11 176795 A (DAINIPPON SCREEN MFG CO LTD), 2. Juli 1999 (1999-07-02)

## Beschreibung

Die Erfindung betrifft eine Vorrichtung und ein Verfahren zur Flüssigkeitsbehandlung eines definierten Bereiches einer Hauptoberfläche eines scheibenförmigen Gegenstandes, insbesondere eines Wafers.

Der Grund für eine Behandlung eines definierten, randnahen Abschnitts eines scheibenförmigen Gegenstandes, insbesondere eines Wafers, soll im folgenden beschrieben werden.

Ein Wafer, beispielsweise ein Siliziumwafer, kann beispielsweise allseitig eine Beschichtung von Siliziumdioxid aufweisen. Für nachfolgende Prozesse (wenn zum Beispiel eine Goldschicht oder eine Schicht aus Polysilizium (polykristallinem Silizium) aufgebracht werden soll) kann es notwendig sein, den Wafer zumindest im Randbereich einer Hauptoberfläche, gegebenenfalls aber auch im Bereich seiner Umfangsfläche und/oder der zweiten Hauptoberfläche von der vorhandenen Beschichtung zu befreien. Dies geschieht durch Ätzverfahren, die sich vor allem in Trockenätzverfahren und Nassätzverfahren untergliedern lassen. Auch kann es erwünscht sein, ein zuvor galvanisch aufgebrachtes Metall (z.B. Kupfer) von bestimmten Bereichen einer Hauptoberfläche eines Halbleitersubstrates zu entfernen. In diesem Fall kann dieser Bereich entweder ein ringförmiger, randnaher Abschnitt sein, oder genau der Bereich der vorderen Hauptoberfläche (Hauptoberfläche auf der sich die Strukturen befinden = device side, in dem sich keine Strukturen befinden, d.h. der chipfreien Zone.

Eine weitere Anwendung ist die Reinigung von Wafern. Hier kann es notwendig sein, den Wafer zumindest im Randbereich einer Hauptoberfläche, gegebenenfalls aber auch im Bereich seiner Umfangsfläche und/oder der zweiten Hauptoberfläche zu reinigen, d.h. von Partikeln und/oder anderen Kontaminationen zu befreien. Dies geschieht durch Nassreinigungsverfahren.

Eine weitere Flüssigkeitsbehandlung ist das Aufbringen von Schichten wie z.B. das galvanische Auftragen von Metallen (Electro-Plating). Dies kann mit oder ohne Strom geschehen, wobei man im letzteren Fall vom "Electroless Electroplating" spricht.

Die Erfindung ist auf das Nassätzen, Nassreinigen oder nasschemische Auftragen von Schichten (zusammengefasst unter dem Begriff Flüssigkeitsbehandlung) gerichtet. Dabei wird der zu behandelnde Flächenabschnitt des Wafers mit der Behandlungsflüssigkeit benetzt und die zu entfernende Schicht bzw. die Verunreinigungen abgetragen oder in diesem Flächenabschnitt eine Schicht aufgebracht.

Während der Flüssigkeitsbehandlung kann der scheibenförmige Gegenstand entweder still stehen oder rotieren (z.B. um seine Achse).

Um zu verhindem, dass die Behandlungsflüssigkeit unkontrolliert auf die nicht zu behandelnde Oberfläche gelangt, wird in der EP 0 316 296 B1 ein Träger (Chuck) vorgeschlagen, der die nicht zu behandelnde, dem Träger zugewandte Oberfläche mit einem Gas spült. Dabei tritt das Gas zwischen der Waferkante und dem Träger aus.

Die JP 09-181026 A beschreibt einen Träger für Halbleiterscheiben der außerhalb einer Ringdüse eine besondere Form, z.B. eine ringförmige, nach außen hin abfallende Stufe oder eine Abschrägung seines Randes, aufweist. Auch wird eine Einsaugöffnung vorgeschlagen. Durch diese Formgebung bzw. die Einsaugöffnung soll die Strömungsgeschwindigkeit im Randbereich beeinflußt (verringert) werden. Dies soll dazu dienen, daß die von oben aufgebrachte Behandlungsflüssigkeit über den Rand des Wafers hinaus auf die dem Chuck zugewandte Seite fließt und dort einen Randbereich behandelt.

Unabhängig davon, ob nun eine Einrichtung zur Aufnahme des scheibenförmigen Gegenstandes (Träger bzw. Chuck) nach EP 0 316 296 B1 oder JP 09-181026 A (englisches Abstract) verwendet wird, kann auf der dem Träger zugewandten Hauptoberfläche maximal ein Randbereich von 1,5 mm (gemessen vom äußeren Rand des Wafers) behandelt werden. Die Flüssigkeit fließt danach wieder in Richtung Waferkante und wird von dieser abgeschleudert. Dieser behandelte Randbereich ist in keinem der beiden Fälle bewusst definiert, vielmehr ist es ein Zufallsergebnis, da die Größe des Randbereiches wesentlich von einer Vielzahl von teilweise einander gegenseitig beeinflussenden Parametern abhängt, wie z.B. Oberflächenbeschaffenheit (Rauhigkeit, Art und Dicke der Adsorptionsschichten), Temperatur, Druck, Luftfeuchtigkeit, etc.

In der US 4,838,289 A wird ein System zum Randätzen eines Wafers beschrieben, bei dem eine Düse gegen den zu ätzenden Bereich der Waferoberfläche gerichtet ist, während der Wafer rotiert. Nachteil dieses Systems ist es, dass der zu behandelnde Bereich nicht genau definiert ist und auch Flüssigkeit auf den Bereich der nicht behandelt werden soll gelangen kann.

In der EP01052682A, die unter Artikel 54(3) EPÜ fällt, wird eine Vorrichtung und ein Verfahren zur Flüssigkeitsbehandlung eines definierten Abschnitts eines scheibenförmigen Gegenstandes beschrieben.

Dementsprechend liegt nun der Erfindung die Aufgabe zugrunde, eine Möglichkeit aufzuzeigen, auf einer Oberfläche eines scheibenförmigen Gegenstandes einen definierten Abschnitt mit einer Flüssigkeit zu behandeln, wobei es u.a. auch möglich sein soll einen Randbereich von über 2 mm (gemessen vom äußeren Rand des scheibenförmigen Gegenstandes) zu behandeln. Bei diesem definierten Abschnitt kann es sich auch um einen innen liegenden Bereich einer Oberfläche des scheibenförmigen Gegenstandes handeln, d.h. ein Bereich, der nicht bis zum Rand des scheibenförmigen Gegenstandes reicht. Wenn auch hier jeweils ein Bereich der von einer Kreislinie nach außen und/oder innen begrenzt ist, so ist dies dennoch nicht notwendig; der zu behandelnde Bereich kann auch z.B. durch ein Vieleck begrenzt sein. Diese Begrenzungslinie kann, wenn es sich bei dem scheibenförmigen Gegenstand um einen Halbleiterwafer handelt, dem Bereich der Oberfläche auf dem sich die Chips befinden ("device area") entsprechen. Demzufolge ist entweder der innere Chip-Bereich oder der äußere, chip-freie Bereich zu behandeln.

Danach schlägt die Erfindung in ihrer allgemeinsten Ausführungsform eine Vorrichtung zur Flüssigkeitsbehandlung eines definierten Abschnitts eines scheibenförmigen Gegenstandes, insbesondere eines Wafers, vor, bestehend aus Haltemittel zum Halten des scheibenförmigen Gegenstandes, einer Maske, die in Form und Größe dem zu behandelnden Bereich des definierten Abschnittes der mit der Flüssigkeit behandelt werden soll entspricht und Distanzmittel, die die Maske und den scheibenförmigen Gegenstand in einem solchen definierten geringen Abstand zueinander halten, dass Flüssigkeit zwischen der Maske und dem definierten Bereich des scheibenförmigen Gegenstandes durch Kapillarkräfte gehalten werden kann, wobei die Vorrichtung keine Gaszuführeinrichtung zur Gasspülung der der Maske zugewandten Oberfläche des scheibenförmigen Gegenstandes aufweist, gemäss Anspruch 1.

Haltemittel können unter anderem sein, Vakuumgreifer, Greifmittel, die den scheibenförmigen Gegenstand an seinem umfangsseitigen Rand berühren oder ein sogenannter Bernoulli-Chuck.

Die Maske ist so ausgestaltet, dass diese, wenn sich ein scheibenförmiger Gegenstand (Wafer) auf dem Träger befindet, den scheibenförmigen Gegenstand (Wafer) nicht berührt, d.h. zwischen dem Wafer und der Maske ein Spalt bleibt. Die Maske normal auf die Hauptoberfläche des Wafers projiziert gibt den Bereich des Wafers an, der mit der Flüssigkeit behandelt wird. Das Material der Oberfläche der Maske, die dem scheibenförmigen Gegenstand zugewandt ist, ist so auszuwählen, dass es von der Flüssigkeit so gut benetzt wird, dass Flüssigkeit in den Spalt zwischen scheibenförmigem Gegenstand und Maske durch Kapillarkraft gehalten wird. Die Summe der beiden Benetzungswinkel der Flüssigkeit einerseits gegen den scheibenförmigen Gegenstand und andererseits gegen die Maske sollte kleiner als 180° sein, vorzugsweise kleiner 150°. Bei vorher ausgewählter Maskenoberfläche kann dies selbstverständlich auch durch der Flüssigkeit zugefügte Additive (Netzmittel) erreicht werden.

Ein Vorteil der erfindungsgemäßen Vorrichtung ist es, dass der zu behandelnde Gegenstand genau in dem zu behandelnden Bereich von der Behandlungsflüssigkeit benetzt wird und zwar ohne dass dieser Bereich von einem festen Körper berührt wird. Gleichzeitig wird vermieden, dass Flüssigkeitströpfchen auf Bereiche gelangen, die nicht behandelt werden sollen bzw. dürfen.

Bei einer vorteilhaften Ausführungsform besitzt die Maske die Form eines Ringes. Der Ring kann in diesem Fall einen Innendurchmesser besitzen, der kleiner ist als der Außendurchmesser des scheibenförmigen Gegenstandes, und einen Außendurchmesser, der mindestens gleich groß ist wie der Außendurchmesser des scheibenförmigen Gegenstandes. Dies ist dann notwendig, wenn die zu behandelnde Fläche ebenfalls die Form eines Ringes aufweist, wie dies z.B. beim Entfernen einer Schicht von einem definierten Randbereich eines Halbleiterwafers der Fall ist.

Vorteilhaft ist, wenn die Distanzmittel die Maske und den scheibenförmigen Gegenstand in einem Abstand von 0,05 bis 1 mm zueinander halten. Bei der Verwendung von dünnflüssigen Medien wie Wasser, Lösungsmittel oder diverse Säuren in wässriger Lösung, wird dadurch verhindert, dass die Flüssigkeit leicht aus dem Kapillarbereich zwischen Maske und scheibenförmigen Gegenstand herausrinnt.

Bei einer Ausführungsform besteht das Distanzmittel aus Greifelementen, die in direktem Kontakt mit dem scheibenförmigen Gegenstand sind und direkt oder indirekt mit der Maske verbunden sind. Dies kann z.B. durch ein außen liegendes Gestänge (indirekt) oder durch z.B. umfangsseitig angeordnete Stifte (direkt) erfolgen.

Bei einer weiteren Ausführungsform sind Maske und Haltemittel relativ zueinander bezüglich einer Rotation um eine senkrecht auf die Maske stehende Achse unbeweglich. Maske und Haltemittel rotieren also beide nicht oder rotiert z.B. das Haltemittel, und mit ihm der scheibenförmige Gegenstand, so rotiert die Maske mit der selben Geschwindigkeit mit. Die fehlende Relativbewegung der Maske zur Oberfläche des scheibenförmigen Gegenstandes ist von Vorteil, wenn die im Kapillarbereich zwischen Maske und scheibenförmigen Gegenstand gehaltene Flüssigkeit, während dem sie in diesem Bereich gehalten wird, möglichst wenig Bewegung in sich erfahren soll. Dadurch wird verhindert, in den Bereich der von der Flüssigkeit nicht behandelt werden soll gelangt.

Weiters kann die erfindungsgemäße Vorrichtung in einer Ausführungsform Distanzveränderungsmittel aufweisen, die den Abstand zwischen der Maske und dem scheibenförmigen Gegenstand zueinander so vergrößern können, dass Flüssigkeit, die sich zwischen Maske und scheibenförmigen Gegenstand befindet nicht mehr durch Kapillarkräfte gehalten wird. Dabei kann es sich um einen Bewegungsmechanismus handeln, der die Haltemittel senkrecht zur Oberfläche des scheibenförmigen Gegenstandes bewegen kann oder um einen Bewegungsmechanismus, der die Maske entsprechend bewegen kann. Es kann aber auch der scheibenförmige Gegenstand direkt entsprechend bewegt werden. Ein Distanzveränderungsmittel kann z.B. ein zusätzlichen Greifer geschehen (z.B. Löffel) oder es sind Stifte (Liftingpins) die den scheibenförmigen Gegenstand anheben.
Durch ein derartiges Distanzveränderungsmittel werden Maske und scheibenförmiger Gegenstand so weit von einander entfernt, dass Flüssigkeit die sich im Bereich dazwischen befunden hat wieder entfernt werden kann. Von Vorteil ist es, wenn das Distanzveränderungsmittel den Abstand um mindestens 0,2 mm, vorzugsweise mindestens 0,5 mm vergrößern kann.

Vorteilhaft ist es wenn die Distarizveränderungsmitte derart ausgestaltet sind, dass diese den Abstand zwischen der Maske und dem scheibenförmigen Gegenstand während oder unmittelbar nach der Flüssigkeitsbehandlung verändern können.
Bei einer Ausführungsform sind Distanzveränderungsmittel und Distanzmittel derart ausgestaltet, dass Elemente des Distanzmittel gleichzeitig Elemente des Distanzveränderungsmittels sind. Hat das Distanzmittel Stifte mit entsprechenden Kerben, die umfangsseitig den scheibenförmigen Gegenstand berühren und dadurch in definiertem Abstand zur Maske halten, so sind diese Stifte gleichzeitig Element des Distanzveränderungsmittels, wenn sie normal zur Oberfläche des scheibenförmigen Gegenstandes bewegt werden können.

Bei einer Ausführungsform sind im wesentlichen senkrecht zu einer Hauptoberfläche des scheibenförmigen Gegenstandes, die Position des scheibenförmigen Gegenstandes umfangsseitig begrenzende Führungselementen angeordneten. Dadurch wird die Position des scheibenförmigen Gegenstandes gegen die Maske bezüglich einer Verschiebung fixiert. Der Abstand der Führungselemente zum Mittelpunkt des scheibenförmigen Gegenstandes kann veränderlich sein.

Auch kann dieser Abstand auf ein so kleines Maß verringerbar sein, dass die Führungselemente den scheibenförmigen Gegenstand festhalten können, und insofern auch Element des Haltemittel sind.
Bei einer Ausführungsform können die Haltemittel in Rotation versetzt werden, wodurch der scheibenförmige Gegenstand rotiert. Dies ist, wenn auch nicht notwendig, so doch vorteilhaft, da die Behandlungsflüssigkeit sowohl vom Träger als auch von der Waferkante abgeschleudert werden kann.

Dieser Spalt zwischen der Maske und dem scheibenförmigen Gegenstand beträgt in einer Ausführungsform 0,05 bis 1 mm, vorteilhafterweise 0,1 bis 0,5 mm. Dadurch bildet sich zwischen dem Wafer und der Maske eine Art Kapillare aus, von der Flüssigkeit, die um die Waferkante geflossen ist, angesaugt wird.

Es ist von Vorteil, wenn die dem scheibenförmigen Gegenstand zugewandte Fläche der Maske zu den Hauptoberflächen des scheibenförmigen Gegenstand parallel ist. Der Spalt zwischen dem scheibenförmigen Gegenstand (Wafer) und der Maske ist dadurch im gesamten Randbereich gleich groß.

Eine Ausführungsform sieht vor, dass der Träger in Rotation versetzt werden kann. Dies ist wenn auch nicht notwendig, so doch vorteilhaft, da die Behandlungsflüssigkeit sowohl vom Träger als auch von der Waferkante abgeschleudert werden kann.

Die Vorrichtung kann zusätzlich eine Flüssigkeitsleitung, die auf die der Maske zugewandte Oberfläche des scheibenförmigen Gegenstandes gerichtet ist, aufweisen. Dadurch kann die Oberfläche, deren definierter erster Bereich mit einer ersten Flüssigkeit behandelt worden ist, auch mit einer zweiten Flüssigkeit behandelt werden und zwar in einem zweiten Bereich der vom ersten verschieden ist. Dieser zweite Bereich kann flächenmäßig größer sein und auch den ersten Bereich vollkommen überdecken. Ist die erste Flüssigkeit z.B. eine Ätzflüssigkeit so kann diese mit Hilfe der zweiten Flüssigkeit (z.B. entionisiertes Wasser) restlos von der der Maske zugewandten Oberfläche entfernen. Gleichzeitig kann dadurch auch die Maske gereinigt bzw. von der ersten Flüssigkeit befreit werden.

Weitere Einzelheiten, Merkmale und Vorteile der Erfindung ergeben sich aus der nachstehenden Beschreibung der in den Zeichnungen gezeigten Ausführungsbeispiele der Erfindung.

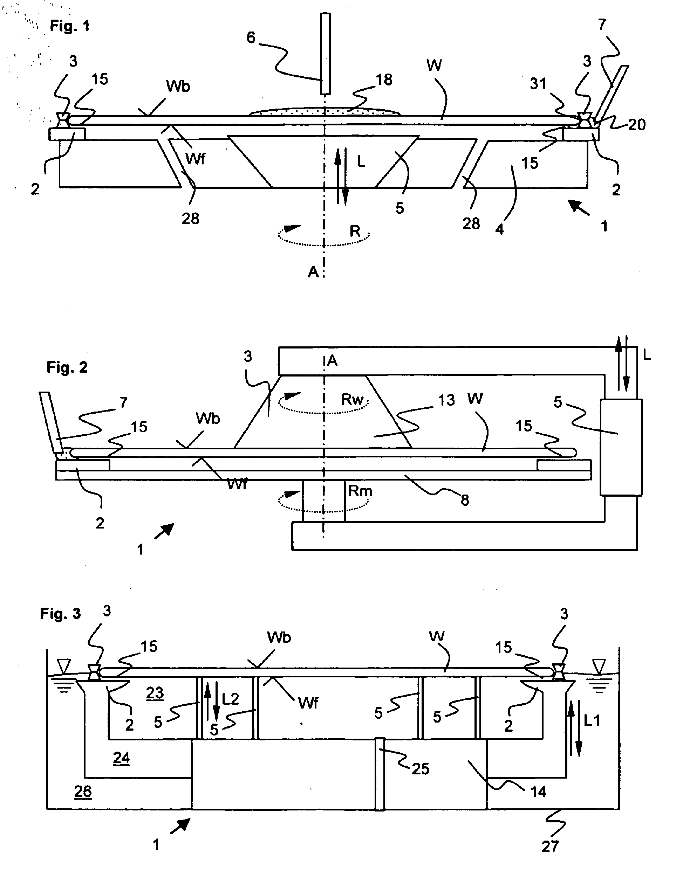

Es zeigt Fig. 1-4 schematisch Achsialschnitte 4 verschiedener erfindungsgemäßer Ausführungsformen.

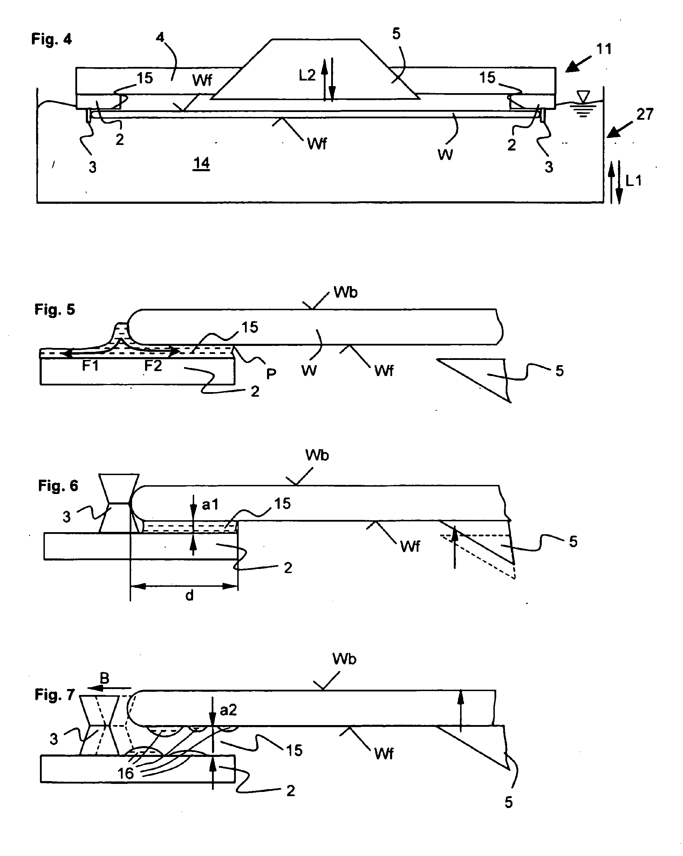

Die Fig. 5-7 zeigen einen schematischen Achsialschnitt einer Ausführungsform nach Fig. 1 in verschiedenen Betriebszuständen.

Fig. 1 zeigt eine Ausführungsform der erfindungsgemäßen Vorrichtung 1. Die Vorrichtung 1 besteht aus einem im wesentlichen runden Grundkörper 4 auf den die Maske 2, die hier die Form eines Ringes besitzt, konzentrisch angebracht ist. Der Ring 2 kann aber auch aus dem Grundkörper herausgearbeitet sein. Der Ring 2 besitzt einen Außendurchmesser der größer und einen Innendurchmesser der kleiner ist als der Außendurchmesser des Wafers. Stifte 3, die auf dem Ring 4 angebracht sind, halten den Wafer W umfangsseitig. Die Stifte 3 besitzen eine Kerbe 31 die in den Waferrand einrastet und so den Wafer in einer definierten horizontalen Lage halten. Die Stifte 3 mit ihren Kerben 31 stellen insofern die Distanzmittel zur Maske 2 dar. Zwischen der Maske 2 und der der Maske zugewandten Waferoberfläche Wf stellt sich dadurch ein definierter Spalt 15 ein. Die Stifte 3 werden über einen nicht dargestellten Mechanismus relativ zur Achse A bewegt, um den Wafer fest zu greifen und zum Entnehmen oder zum Anheben des Wafers diesen wieder freizugeben. Innerhalb des Grundkörpers 4 ist ein Hebemechanismus 5 .(Distanzveränderungsmittel) angeordnet, der in Pfeilrichtung L auf und ab bewegt werden kann, und insofern den Abstand zwischen dem Wafer W und der Maske 2 verändern kann. Der Hebemechanismus besteht aus einem Träger, der eine dem Wafer zugewandte im wesentlichen ebene und zum Wafer parallel Fläche besitzt, die wenn der Träger angehoben wird erst den Wafer an seiner unteren Oberfläche Wf berührt und dann den Wafer anhebt. Die gesamt Vorrichtung 1, und mit ihr der Wafer, kann um die Waferachse A rotieren.

Die Behandlungsflüssigkeit kann entweder durch die außerhalb in der Nähe des Waferrandes angebrachte Düse 7 oder durch eine Düse 6 aufgebracht werden, die gegen die der Maske 2 abgewandte Waferoberfläche Wb gerichtet ist. Im ersten Fall (Düse 7) wird eine Flüssigkeitsmenge 20 unmittelbar beim Waferrand auf die Maske 2 aufgebracht. Die Flüssigkeit wird sodann von dem kapillarartigen Spalt 15 eingezogen und benetzt so genau den Bereich der der Maske 2 zugeordneten Waferoberfläche Wf, der von der Maske 2 überlappt wird. Im zweiten Fall (Düse 6) wird die Flüssigkeitsmenge 18 auf die der Maske 2 abgewandte Oberfläche Wf z.B. in deren Zentrum aufgetragen, die Flüssigkeit rinnt sodann radial nach außen zum Waferrand, was durch Rotation des Wafers unterstützt werden kann. Daraufhin fließt die Flüssigkeit um den Waferrand und wird vom Spalt 15 eingezogen. In beiden Fällen kann der Wafer während der gesamten Flüssigkeitsbehandlung rotieren (R), was den Vorteil hat, dass überschüssige Flüssigkeit, die nicht in den Spalt 15 eindringt, nicht unkontrolliert über die Maske 2 nach unten abfließt, sondern kontrolliert abgeschleudert wird. Anschließend wird auf die der Maske 2 zugewandte Waferoberfläche Wf eine zweite Flüssigkeit (z.B. deionisiertes Wasser) über die Flüssigkeitsleitung 28 aufgebracht, gleichzeitig rotiert der Täger 4, wodurch die zweite Flüssigkeit die Flüssigkeit die sich im Spalt 15 befindet verdrängt. Gleichzeitig, davor oder auch danach wird der Wafer mit dem Hebemechanismus 5 angehoben.

Fig. 2 zeigt eine weitere Ausführungsform. Die Maske 2 (Ring) wird von einer Scheibe 8 getragen. Der Wafer W wird an seiner der Maske abgewandten Oberfläche Wb durch einen rotierbaren Vakuumträger 13 (vacuum-chuck) gehalten. Dies hat den Vorteil, dass weder der Waferrand noch die der Maske zugewandte Waferoberfläche Wf berührt werden. Sowohl der den Wafer W haltende Träger 13 als auch die Maske 2 können um die selbe Achse A gedreht werden, der Träger in Richtung Rw und die Maske in Richtung Rm. Geschieht dies mit der selben Umdrehungsgeschwindigkeit und in die selbe Richtung so werden Maske und Wafer relativ zueinander nicht bewegt (Rw = Rm). Träger 13 und Maske 2 sind über ein Distanzveränderungsmittel 5 mit einander verbunden und werden durch dieses von einander weg und auf einander zu bewegt (Pfeile L). Dieses Distanzveränderungsmittel 5 kann z.B. ein Pneumatikzylinder oder eine Spindel sein. Mit Hilfe dieses Distanzveränderungsmittels 5 kann der Spalt 15 zwischen Wafer und Maske exakt eingestellt werden, daher stellt es gleichzeitig ein Distanzmittel dar. Durch eine Düse 7 wird eine Flüssigkeitsmenge 20 unmittelbar beim Waferrand auf die Maske 2 aufgebracht. Die Flüssigkeit wird sodann von dem kapillarartigen Spalt 15 eingezogen.

Fig. 3 zeigt eine dritte Ausführungsform. Die Vorrichtung 1 besteht aus einem Badbehälter 27 in dem sich ein topfförmiger Träger 24 befindet. Der Raum 23 innerhalb des Trägers ist gegen das zwischen Träger und Badbehälter befindlichen Bad 26 abgedichtet. Der Träger 24 kann mit Hilfe des Hebemechanismus aus dem Bad 26 gehoben werden. Der obere Rand des Trägers hat die Form eines Ringes 2 der die Maske darstellt, mit einer zum Wafer W zugewandten und zu dessen Oberflächen Wf planparallelen Fläche. Auf diesem Ring 2 (Maske) befinden sich Stifte 3 mit Kerben, die den Wafer in definiertem Abstand zur Maske halten, wodurch sich ein Spalt 15 ausbildet. Der Träger 2 mit dem darauf befindlichen Wafer W wird so weit in das Bad abgesenkt (L1), dass sich der Flüssigkeitsspiegel etwas oberhalb des Ringes befindet, sodass der Waferrand benetzt wird. Die Flüssigkeit wird durch Kapillarkräfte in den Spalt 15 zwischen Wafer und Maske eingezogen. Um ein Eindringen von Flüssigkeit in den Raum 23 innerhalb des Trägers infolge von darin befindlichen Unterdrucks zu verhindem, steht der Raum über das Rohr 25 mit der Umgebung in Verbindung. Auch kann über dieses Rohr 25 leichter Überdruck in dem Raum 23 innerhalb des Trägers aufgebaut werden, wird der Träger wieder aus dem Bad gehoben (L1). Nach der Flüssigkeitsbehandlung wird die im Spalt 15 befindliche Flüssigkeit mit Hilfe von stärkerem Überdruck, aufgebaut durch ein durch das Rohr 25 zugeführtes Gas, radial nach außen gedrückt. Auch kann der Spalt 15 mit einem Distanzveränderungsmittel 5 vergrößert werden. Hier sind vier auf und ab bewegliche Stifte 5 gezeigt, die den Wafer innerhalb der Maske 2 an seiner der Maske zugeordneten Fläche berühren und senkrecht anheben können (L2).

Fig. 4 zeigt eine vierte Ausführungsform. Die Vorrichtung besteht aus einem Bad 14, in dem sich die Behandlungsflüssigkeit befindet und das auf und ab bewegt werden kann (Pfeile L1) und einem Träger 11. Der Träger 11 besteht aus einem Grundkörper 4 und einem unten angeformten Ring 2. Stifte 3 mit Kerben, die auf dem Ring 2 unten angebracht sind, halten den Wafer W umfangsseitig, und zwar in definiertem Spaltabstand zum Ring 2, sodass der Wafer in waagrechter Position unten am Träger hängt. Der Träger 11 samt Wafer W wird in das Bad 27 so weit eingetaucht, dass der Flüssigkeitsspiegel den Ring 2 benetzt, und somit die dem Ring abgewandte Oberfläche Wb des Wafers und der umfangsseitige Waferrand vollständig benetzt wird. Die Flüssigkeit dringt in den Spalt zwischen Wafer und Ring ein. Der Träger 11 wird nach der Behandlung aus dem Bad gehoben. Ein innerhalb des Trägers montierter Vakuumgreifer (vacuum-pickup) 5 wird nach unten bewegt, sodass er den Wafer an der der Maske zugewandten Oberfläche Wf des Wafers berührt und ansaugt. Danach wird der Wafer mit dem Greifer weiter nach unten bewegt und so die Kapillarkraft wodurch die Flüssigkeit innerhalb des Spaltes 15 gehalten wird überwunden. Durch Rotation des Greifers können eventuell auf dem Wafer verbleibende Flüssigkeitsreste abgeschleudert werden.

Anhand der Fig. 5-7 soll nun die Betriebsweise einer erfindungsgemäßen Vorrichtung beschrieben werden, wobei von der Ausführungsform der Fig. 1 ausgegangen wird. Zuerst wird der Wafer W in die Nähe der Maske 2 gebracht, wodurch sich der Spalt 15 ausbildet. Der definierte Abstand zwischen der Maske 2 und dem Wafer wird durch Distanzmittel gewährleistet, hier die Stifte 3 (Fig. 5) mit Kerben. Nun wird Flüssigkeit entweder auf die der Maske abgewandte Waferoberfläche Wb oder direkt an den Waferrand aufgetragen. Die Flüssigkeit tritt zum Teil in den Spalt 15 ein (F2). Der überschüssige Teil der Flüssigkeit F1 rinnt ab bzw. wird wenn die Maske und/oder der Wafer rotieren abgeschleudert. Die Flüssigkeit kann nicht weiter nach innen rinnen als die innere Kontur der Maske 2 ist, d.h. sie dringt nur bis zum Punkt P vor. Der Abstand a1 zwischen der Maske 2 und dem Wafer wird so klein gewählt, dass die Flüssigkeit durch Kapillarkräfte innerhalb des Spaltes 15 gehalten wird, und dort die Waferoberfläche behandelt. Ein Hebemechanismus 5 tritt nun in Kontakt mit der der Maske 2 zugewandten Waferoberfläche Wf, die Stifte 3 werden nun geöffnet (B) und der Hebemechanismus 5 hebt den Wafer soweit an, dass der Flüssigkeitsfilm im Spalt 15 reißt und nur mehr Tropfen 16 auf der Maske und/oder der Waferoberfläche bleiben. Diese Tropfen 16 können nun abgespült, abgeblasen und/oder abgeschleudert werden.

## Patentansprüche

1. Vorrichtung zur Flüssigkeitsbehandlung eines definierten, Abschnitts eines scheibenförmigen Gegenstandes (W), insbesondere eines Wafers, bestehend aus
1.1 Haltemittel (3, 53) zum Halten des scheibenförmigen Gegenstandes,
1.2 einer Maske (2) die in Form und Größe dem zu behandelnden Bereich des definierten Abschnittes der mit der Flüssigkeit behandelt werden soll entspricht,
1.3 Distanzmittel (3, 31, 45, 41), die die Maske und den scheibenförmigen Gegenstand in einem solchen definierten geringen Abstand zueinander halten, dass Flüssigkeit zwischen der Maske und dem definierten Bereich des scheibenförmigen Gegenstandes (15) durch Kapillarkräfte gehalten werden kann,
wobei die Vorrichtung keine Gaszuführeinrichtung zur Gasspülung der der Maske zugewandten Oberfläche des scheibenförmigen Gegenstandes aufweist.

2. Vorrichtung nach Anspruch 1, bei der die Maske (2) die Form eines Ringes besitzt.

3. Vorrichtung nach Anspruch 2, bei der der Ring einen Innendurchmesser besitzt, der kleiner ist als der Außendurchmesser des scheibenförmigen Gegenstandes, und einen Außendurchmesser, der mindestens gleich groß ist wie der Außendurchmesser des scheibenförmigen Gegenstandes.

4. Vorrichtung nach Anspruch 1, bei der die Distanzmittel die Maske und den scheibenförmigen Gegenstand in einem Abstand (a1) von 0,05 bis 1 mm halten.

5. Vorrichtung nach Anspruch 1, wobei das Distanzmittel aus Greifelementen (3, 53) besteht, die in direktem Kontakt mit dem scheibenförmigen Gegenstand sind und direkt oder indirekt mit der Maske (2) verbunden sind.

6. Vorrichtung nach Anspruch 1, bei der Maske und Haltemittel relativ zueinander bezüglich einer Rotation um eine senkrecht auf die Maske stehende Achse (A) unbeweglich sind.

7. Vorrichtung nach Anspruch 1, die Distanzveränderungsmittel (5, 44, 49) aufweist, die den Abstand (a1) zwischen der Maske und dem scheibenförmigen Gegenstand zueinander so vergrößern (a2) können, dass Flüssigkeit, die sich zwischen Maske und scheibenförmigen Gegenstand befindet, nicht mehr durch Kapillarkräfte gehalten wird.

8. Vorrichtung nach Anspruch 7, wobei die Distanzveränderungsmittel derart ausgestaltet sind, dass diese den Abstand zwischen der Maske und dem scheibenförmigen Gegenstand während oder unmittelbar nach der Flüssigkeitsbehandlung verändern können.

9. Vorrichtung nach Anspruch 7, bei dem die Elemente des Distanzmittel gleichzeitig Elemente des Distanzveränderungsmittels sind.

10. Vorrichtung nach Anspruch 1, mit im wesentlichen senkrecht zu einer Hauptoberfläche des scheibenförmigen Gegenstandes angeordneten, die Position des scheibenförmigen Gegenstandes umfangsseitig begrenzenden Führungselementen (3, 53).

11. Vorrichtung nach Anspruch 1, bei der die Haltemittel in Rotation (R) versetzt werden können.

12. Vorrichtung nach Anspruch 1, mit einer Flüssigkeitsleitung (28), die auf die der Maske zugewandte Oberfläche des scheibenförmigen Gegenstandes gerichtet ist.

## Claims

1. An apparatus for the liquid treatment of a defined section of a disk-like object (W), especially a wafer, consisting of:
1.1. a holding means (3, 53) for holding the disk-like object;
1.2. a mask (2) which corresponds with respect to its shape and size to the area of the defined section to be treated with the liquid;
1.3. distance means (3, 31, 45, 41) which hold the mask and the disk-like object at such a defined low distance from each other that liquid can be held by capillary forces between the mask and the defined area of the disk-like object (15), with the apparatus not comprising any gas feeding device for gas purging of the surface of the disk-like object facing the mask.

2. An apparatus according to claim 1, wherein the mask (2) has the shape of a ring.

3. An apparatus according to claim 2, wherein the ring has an inside diameter which is smaller than the outside diameter of the disk-like object and an outside diameter which is at least as large as the outside diameter of the disk-like object.

4. An apparatus according to claim 1, wherein the distance means hold the mask and the disk-like object at a distance (a1) of 0.05 to 1 mm.

5. An apparatus according to claim 1, wherein the distance means consists of gripping elements (3, 53) which are in direct contact with the disk-like object and are connected directly or indirectly with the mask (2).

6. An apparatus according to claim 1, wherein the mask and the holding means are immobile relative to each other with respect to a rotation about an axis (A) standing perpendicular to the mask.

7. An apparatus according to claim 1, comprising distance changing means (5, 44, 49) which can increase the distance (a1) between the mask and the disk-like object from each other in such a way (a2) that liquid disposed between the mask and the disk-like object is no longer held by capillary forces.

8. An apparatus according to claim 7, wherein the distance changing means are arranged in such a way that they can change the distance between the mask and the disk-like object during or directly after the liquid treatment.

9. An apparatus according to claim 7, wherein the elements of the distance means are simultaneously elements of the distance changing means.

10. An apparatus according to claim 1, comprising guide elements (3, 53) which are arranged substantially perpendicular to a principal surface of the disk-like object and delimit the position of the disk-like object on the circumferential side.

11. An apparatus according to claim 1, wherein the holding means can be made to rotate (R).

12. An apparatus according to claim 1, comprising a liquid line (28) which is directed against the surface of the disk-like object facing the mask.

## Revendications

1. Dispositif pour le traitement par un liquide d'une partie définie d'un objet en forme de plaque (W), en particulier d'une plaquette, comprenant
1.1 des moyens de fixation (3, 53) pour la fixation de l'objet en forme de plaque,
1.2 un masque (2) dont la forme et la taille correspondent à la surface à traiter de la partie définie qui doit être traitée avec le liquide,
1.3 des moyens d'écartement (3, 31, 45, 41) qui retiennent le masque et l'objet en forme de plaque à une petite distance définie l'un de l'autre telle que du liquide puisse être retenu par capillarité entre le masque et la partie définie de l'objet en forme de plaque (15),
lequel dispositif ne présente pas de dispositif d'arrivée de gaz pour l'irrigation avec un gaz de la surface de l'objet en forme de plaque tournée vers le masque.

2. Dispositif selon la revendication 1, dans lequel le masque (2) a la forme d'un anneau.

3. Dispositif selon la revendication 2, dans lequel l'anneau a un diamètre intérieur plus petit que le diamètre extérieur de l'objet en forme de plaque et un diamètre extérieur qui est au moins aussi grand que le diamètre extérieur de l'objet en forme de plaque.

4. Dispositif selon la revendication 1, dans lequel les moyens d'écartement retiennent le masque et l'objet en forme de plaque à une distance (a1) de 0,05 à 1 mm.

5. Dispositif selon la revendication 1, dans lequel les moyens d'écartement se composent d'éléments de préhension (3, 53) qui sont en contact direct avec l'objet en forme de plaque et reliés directement ou indirectement avec le masque (2).

6. Dispositif selon la revendication 1, dans lequel le masque et les moyens de fixation sont immobiles l'un par rapport à l'autre dans le sens d'une rotation sur un axe (A) vertical perpendiculaire au masque.

7. Dispositif selon la revendication 1 comportant des moyens de modification de la distance (5, 44, 49) qui peuvent augmenter (a2) la distance (a1) entre le masque et l'objet en forme de plaque de telle sorte que le liquide qui se trouve entre le masque et l'objet en forme de plaque ne soit plus retenu par capillarité.

8. Dispositif selon la revendication 7, dans lequel les moyens de modification de la distance sont conçus de façon à pouvoir modifier cette distance entre le masque et l'objet en forme de plaque pendant ou immédiatement après le traitement avec le liquide.

9. Dispositif selon la revendication 7, dans lequel les éléments des moyens d'écartement sont en même temps des éléments des moyens de modification de la distance.

10. Dispositif selon la revendication 1, avec des éléments de guidage (3,53) sensiblement perpendiculaires à une surface principale de l'objet en forme de plaque, qui délimitent la position de l'objet en forme de plaque sur sa circonférence.

11. Dispositif selon la revendication 1, dans lequel les moyens de fixation peuvent être entraînés en rotation (R).

12. Dispositif selon la revendication 1, avec une conduite de liquide (28) qui est dirigée vers la surface de l'objet en forme de plaque orientée vers le masque.
